Europäisches Patentamt

**European Patent Office**

Office européen des brevets

(11) Veröffentlichungsnummer: **0 045 416**
**B1**

(12) # EUROPÄISCHE PATENTSCHRIFT

(45) Veröffentlichungstag der Patentschrift:
31.10.84

(51) Int. Cl.³: **C 23 C 13/02**

(21) Anmeldenummer: 81105603.5

(22) Anmeldetag: 16.07.81

(54) Verfahren zur Erzeugung einer Schutzschicht auf metallischen Werkstücken.

(30) Priorität: 02.08.80 DE 3029488

(43) Veröffentlichungstag der Anmeldung:
10.02.82 Patentblatt 82/6

(45) Bekanntmachung des Hinweises auf die Patenterteilung:
31.10.84 Patentblatt 84/44

(84) Benannte Vertragsstaaten:
CH DE FR GB LI SE

(56) Entgegenhaltungen:
CA - A - 403 440
DE - A - 2 836 745
DE - B - 1 221 875
FR - A - 2 100 817
FR - A - 2 226 484
US - A - 3 305 384
US - A - 3 993 454

METAL PROGRESS, February 1979, Selten 26-31 W.A. McGILL et al.: "Aluminium diffused steels resist high temperatures in hydrocarbon environments"
C.F. POWELL et al.: "Vapor deposition", 1966, John Wiley & Sons New York, U.S.A. Selte 531
L. HOLLAND: "Vacuum deposition of thin films", 1970, pages 344, 345 Chapman and Hall Ltd. London, G.B.

(73) Patentinhaber: **GHT Gesellschaft für Hochtemperaturreaktor-Technik mbH, Postfach, D-5060 Bergisch-Gladbach 1 (DE)**

(72) Erfinder: **Bates, Antony, The Beeches Barrow Hill, Bere-Regis Wareham BH20 7JB (GB)**
Erfinder: **Cook, Roger, Dr., Sandy Croft 17 Sandy Lane, Colehill Wimborn, BH21 2NE (GB)**
Erfinder: **Brenner, Karl, Dr., 106 Wedgewood Drive, Poole BH14 8EX (GB)**
Erfinder: **Leslie, Graham, Dr., 52 Blandford RD., Corfe-Mullen Wilborn, BH21 3HO (GB)**
Erfinder: **Warren, Michael, Dr., 17 Egdon Glen, Crossways Dorchester (GB)**
Erfinder: **Demel, Otto, Dr., Lenaugasse 10, A-1082 Wien (AT)**

(74) Vertreter: **Mehl, Ernst, Dipl.-Ing. et al, Postfach 22 01 76, D-8000 München 22 (DE)**

## Beschreibung

Die vorliegende Erfindung betrifft ein Verfahren der durch den Oberbegriff des ersten Anspruchs definierten Art. Es ist besonders geeignet für die Behandlung von Werkstücken, die in dem mit Helium betriebenen Kühlkreislauf eines Hochtemperaturkernreaktors eingesetzt werden sollen. Der Einsatz derartiger Reaktoren wird in Betracht gezogen u. a. für die Kohleveredelung, z. B. die Erzeugung von synthetischem Erdgas. Dies bringt es mit sich, daß in dem Kühlkreislauf mit dem Vorhandensein kleiner Verunreinigungen durch Methan und Wasserstoff gerechnet werden muß. Es hat sich gezeigt, daß die wegen ihrer an sich guten Warmfestigkeit vorgeschlagenen sogenannten Superlegierungen auf Nickelbasis bei den hohen Betriebstemperaturen von 800 bis 1000°C zur Aufkohlung und zu interkristalliner Korrosion neigen.

Es ist bekannt, Werkstücke, die bei hoher Temperatur einer korrosiven Atmosphäre ausgesetzt werden (z. B. die Schaufeln von Gasturbinen) durch das Aufbringen einer Schicht aus einem korrosionsbeständigen Material zu schützen. Ebenfalls bekannt ist die Eigenschaft des Aluminiums, in oxidierender Atmosphäre eine dichte, nach ihrer Ausbildung gegen weitere Oxidation hemmende Oxidschicht auszubilden. Aus der GB-PS 1 542 694 ist ein Verfahren bekannt, bei dem ein Grundmaterial auf Nickelbasis mit einer Schutzschicht aus Chrom, Aluminium, Hafnium, Nickel und/oder Kobalt versehen wird. Trotz der für diese Schutzschicht in Anspruch genommenen besseren Haftfestigkeit auf dem Grundmaterial besteht insbesondere bei häufigen Temperaturwechseln die Gefahr des Abblätterns der Schutzschicht. An etwaigen, u. U. erst während des Betriebes auftretenden Fehlstellen der Schutzschicht ist das Grundmaterial nicht mehr gegen den Angriff der korrosiven Atmosphäre geschützt. Aus der DE-OS 2 836 745 ist ein Verfahren bekannt, bei dem zur Verringerung der Wasserstoffpermeabilität von Metalloberflächen vorgeschlagen wird, das Werkstück einer an sich bekannten Kalorisierungsbehandlung zu unterziehen, durch die zwischen einer hauptsächlich aus Aluminiumoxid bestehenden Schutzschicht von etwa 150 µm Dicke und dem Grundmaterial eine etwa 120 µm dicke Diffusionsschicht gebildet wird, die eine hohe Temperaturwechselfestigkeit der Schutzschicht gewährleisten soll.

Aufgabe der vorliegenden Erfindung ist ein verbessertes Verfahren zur Erzeugung von Schutzschichten auf metallischen Werkstücken, die hohen Temperaturen und auch Temperaturwechseln widerstehen, und das eine Aufkohlung und Korrosion des Grundmaterials verhindert und darüber hinaus eine Verringerung der Permeabilität des Werkstoffes für Wasserstoff und seine Isotope bewirkt. Die zu erzeugende Schutzschicht soll selbstheilend sein, d. h. sie soll sich bei örtlicher Zerstörung durch mechanische oder andere Einflüsse selbsttätig neu bilden. Diese Eigenschaft ist besonders wichtig für Bauteile komplizierter Form, z. B. für Wärmetauscher, bei denen das Auftragen einer Schutzschicht auf herkömmliche Art und Weise, z. B. durch einen Anstrich nur schwer möglich ist, wobei stets die Gefahr des Auslassens einzelner Stellen der Oberfläche besteht.

Die Lösung dieser Aufgabe erfolgt durch die im kennzeichnenden Teil des ersten Anspruchs angegebenen Verfahrensschritte. Der Materialaufwand für die Herstellung der Schutzschicht wird gegenüber dem bekannten Verfahren drastisch reduziert. Derartig dünne Schichten sind naturgemäß auch weniger empfindlich gegen plötzliche Temperaturwechsel als die bislang bekannte, um Größenordnungen dickeren Schichten. Die Zusammensetzung des so behandelten Werkstückes wird in der Oberflächenschicht geringfügig verändert, was ohne Einfluß auf seine sonstigen Eigenschaften bleibt. Bei hohen Temperaturen können aus dieser Diffusionsschicht Aluminiumionen an die Oberfläche wandern und dort durch Oxidation eine das Material schützende Schicht bilden, und zwar schneller, als Sauerstoff eindiffundieren und zu Oxidationserscheinungen in größerer Tiefe führen kann. Es hat sich gezeigt, daß dadurch gleichzeitig eine Aufkohlung des Werkstoffs an seiner Oberfläche weitgehend unterbunden wird.

Wie im zweiten Anspruch vorgeschlagen, kann man den dritten Verfahrensschritt an den Einsatzort des Werkstückes selbst verlegen. Es wird dadurch sichergestellt, daß die Schutzschicht sich über die gesamte Oberfläche des Werkstückes erstreckt ohne Rücksicht auf Fabrikationsfehler, Beschädigungen während der Montage usw.

Das nachfolgend aufgeführte Beispiel dient zur näheren Erläuterung der durch die Anmeldung des Verfahrens erzielten Vorteile.

Es wurde ein Grundmaterial mit folgender Zusammensetzung verwendet (in Gewichts-%):

| C | Si | Mn | Cr | Ni | Fe | Mo | Co | Ti | Al |
|---|----|----|-----|------|------|------|-------|------|------|
| 0,07 | 0,08 | 0,02 | 22,31 | Rest | 0,15 | 9,09 | 12,46 | 0,35 | 1,06 |

Dieses Material wurde 2000 Stunden lang bei 1000"C Helium mit den folgenden durchschnittlichen Verunreinigungen ausgesetzt (in $\mu$ bar):

| $H_2O$ | $H_2$ | $CH_4$ | CO |
|---|---|---|---|
| 1,50 | 495,2 | 52,6 | 51,3 |

Dabei ergaben sich die folgenden Resultate, wobei Werkstücke aus dem gleichen Material den gleichen Bedingungen ausgesetzt wurden, die jedoch entweder völlig unbehandelt oder nur diffusionsgeglüht waren.

| Material | Oberfläche | Innere Oxidation | Ausscheidungsarme Zone | Aufkohlung |
|---|---|---|---|---|
| unbehandelt | bis in 15 μm Tiefe unregelmäßige Karbide u. Oxide | feine Oxidation bis in 30 μm Tiefe | bis in 55 μm Tiefe | +0,371% C |
| Al-beschichtet und Diffusionsglühung | etwa 1 μm Dicke kontinuierliche geschlossene Oxidschicht | keine | keine | +0,007% C |
| Nur Diffusionsglühung | bei etwa 8 μm unregelmäßige Oxid- u. Karbidschicht | feine Oxidation bis in 80 μm Tiefe | bis in 15 μm Tiefe | +0,107% C |

## Patentansprüche

1. Verfahren zur Erzeugung einer Schutzschicht auf Werkstücken aus einer Nickel-Legierung, gekennzeichnet durch folgende Verfahrensschritte:

a) Einem ersten Schritt, in dem eine Aluminiumschicht in etwa 1μm Dicke im Vakuum auf das Werkstück aufgedampft wird.

b) Einem zweiten Schritt, in dem die Aluminiumschicht bei einem Sauerstoffpartialdruck von weniger als $1 \times 10^{-6}$ bar und einer Temperatur von etwa 550°C bis zu einer Tiefe von etwa 10 μm eindiffundiert wird.

c) Einem dritten Schritt, in dem die Oberfläche des Werkstücks in Heliumatmosphäre mit einem Sauerstoffpartialdruck von weniger als $10 \times 10^{-20}$ bar, einem Verhältnis von Wasserstoff zu Wasser größer als 10 : 1 und einer Temperatur über 800°C oxidiert wird.

2. Verfahren nach Anspruch 1 für Werkstücke, die im Einsatz hohen Temperaturen in schwach oxidierender Atmosphäre ausgesetzt sind, daduch gekennzeichnet, daß der dritte Schritt während und durch den Einsatz erfolgt.

## Claims

1. A process for the production of a protective layer on workpieces made of a nickel alloy, characterised by the following process steps:

a) a first step, in which an aluminium layer having a thickness of approximately 1 μm is vapour-deposited onto the workpiece in vacuum;

b) a second step, in which the aluminium layer is diffused to a depth of approximately 10 μm under an oxygen partial pressure of less than $1 \times 10^{-6}$ bar and at a temperature of approximately 550°C; and

**0 045 416**

c) a third step, in which the surface of the workpiece is oxidized in a helium atmosphere with an oxygen partial pressure of less than $10 \times 10^{-20}$ bar, a hydrogen to water ratio greater than 10 : 1 and a temperature above 800° C.

2. A process according to Claim 1 for workpieces which are exposed in use to high temperatures in a weakly oxidising atmosphere, characterised in that the third step is carried out during and by such use.


## Revendications

1. Procédé pour produire une couche protectrice sur des pièces métalliques en alliages de nickel, caractérisé par les stades de procédé suivants:

a) Un premier stade dans lequel on dépose sur la pièce, par dépôt en phase vapeur sous vide, une couche d'aluminium de 1 micron d'épaisseur environ.
b) Un deuxième stade dans lequel on fait diffuser la couche d'aluminium sous une pression partielle d'oxygène inférieure à $1 \times 10^{-6}$ bars et à une température de 550° C environ, jusqu'à une profondeur de 10 microns environ.
c) Un troisième stade dans lequel on oxyde la surface de la pièce en atmosphère d'hélium sous une pression partielle d'oxygène inférieure à $10 \times 10^{-1}$ bars, avec un rapport de l'hydrogène à l'eau supérieur à 10 : 1 et à une température supérieure à 800° C.

2. Procédé suivant la revendication 1 pour des pièces qui sont soumises en utilisation à des températures élevées et dans des atmosphères faiblement oxydantes, caractérisé en ce qu'il consiste à effectuer le troisième stade pendant l'utilisation et par l'utilisation.

4